# EUROPEAN PATENT SPECIFICATION

(11) **EP 3 405 980 B1**
(45) Date of publication and mention of the grant of the patent: **23.06.2021**
(21) Application number: 16812667.0
(22) Date of filing: 20.05.2016
(51) Int. Cl.: H01L 29/786, H01L 29/66

(54) **OXIDE SEMICONDUCTOR MATERIAL, THIN-FILM TRANSISTOR, AND FABRICATION METHOD THEREOF**
OXIDHALBLEITERMATERIAL, DÜNNSCHICHTTRANSISTOR UND HERSTELLUNGSVERFAHREN DAFÜR
MATÉRIAU OXYDE SEMI-CONDUCTEUR, TRANSISTOR À COUCHES MINCES, ET LEURS PROCÉDÉS DE FABRICATION

(30) Priority: 22.01.2016 CN 201610045906
(43) Date of publication of application: 28.11.2018
(73) Proprietor: BOE Technology Group Co., Ltd., Beijing 100015 (CN); South China University of Technology, Guangdong 510640 (CN)
(72) Inventor: YAN, Liangchen, Beijing 100176 (CN); YUAN, Guangcai, Beijing 100176 (CN); XU, Xiaoguang, Beijing 100176 (CN); WANG, Lei, Beijing 100176 (CN); PENG, Junbiao, Beijing 100176 (CN); LAN, Linfeng, Beijing 100176 (CN)
(74) Representative: Cohausz & Florack
(86) International application number: PCT/CN2016/082904
(87) International publication number: WO 2017/124672

(56) References cited:
- CN-A- 104 916 703
- CN-A- 105 097 943
- CN-A- 105 097 943
- CN-A- 105 321 827
- US-A1- 2007 184 576
- US-A1- 2007 184 576
- US-A1- 2011 001 136
- US-A1- 2014 264 155
- US-A1- 2014 312 320
- US-A1- 2015 372 023

## Description

### CROSS-REFERENCE TO RELATED APPLICATION

The present application claims priority to Chinese Patent Application No. 201610045906.4 filed on January 22, 2016.

### TECHNICAL FIELD

The present disclosure relates generally to the field of display technologies, and more specifically to an oxide semiconductor material, a thin-film transistor, and a fabrication method thereof.

### BACKGROUND

In recent years, thin film transistors (TFTs) have drawn more attention in the field of flat-panel displays, especially in the area of organic light-emitting diode (OLED) displays.

Silicon, such amorphous silicon (a-Si), polycrystalline silicon (p-Si), and mirocystalline silicon (m-Si), etc., has been the primary material for the semiconductor layer in a TFT used in flat-panel displays. However, an a-Si-based TFT has drawbacks including high sensitivity to light, low electron mobility (e.g., < 1cm²/Vs), and low stability. A p-Si based TFT has a relatively high electron mobility, but has an issue of low electrical uniformity due to influences by the grain boundaries, and has disadvantages including high preparation temperature, high cost, and difficulty in large-area crystalization, which all limit its applications in flat-panel displays. An m-Si-based TFT is difficult to prepare, and it is difficult to control the crystalline particles. As such, the m-Si-based TFT may be difficult for large-scale manufacturing.

Due to the various disadvantages of the semiconductor layers fabricated by traditional silicon-based approaches, oxide semiconductor layers have emerged as an advantageous new technology for their relatively high electron mobility and transparency to visible light. Oxide semiconductor layers have gradually replaced the traditional silicon-based semiconductor layers to become a mainstream technology in the field of TFT flat-panel displays.

In current technologies, oxides employed in oxide semiconductor layers primarily include indium gallium zinc oxide (IGZO) and indium zinc oxide (IZO). Due to their sensitivity to acids, IGZO and IZO may be unsuitable for forming source layers and drain layers through wet etching. For this reason, current fabrication technologies require addition of a barrier layer on the surface of the semiconductor layers, serving to prevent the semiconductor layers from being damaged by the etching solution. As such, fabrication of thin-film transistors typically involves tedious processes and incurs higher cost. In addition, there is only limited amount of indium on earth, leading to higher indium prices, in turn adding extra cost to the TFTs.

US patent application US 2014/264155 A1 discloses methods and formulations for the selective etching of etch stop layers deposited above metal-based semiconductor layers used in the manufacture of TFT-based display devices are presented. The formulations are based on an alkaline solution. Methods and formulations for the selective etching of molybdenum-based and/or copper-based source/drain electrode layers deposited, above metal-based semiconductor layers used in the manufacture of TFT-based display devices are presented. The formulations are based on an alkaline solution.

US patent application US 2011/001136 A1 provides an oxide semiconductor material, a method for manufacturing such oxide semiconductor material, an electronic device and a field effect transistor. The oxide semiconductor material contains Zn, Sn, and O, does not contain In, and has an electron carrier concentration higher than 1×1015/cm3 and less than 1×1018/cm3. The electronic device comprises a semiconductor layer formed of the oxide semiconductor material, and an electrode provided on the semiconductor layer. The field effect transistor comprises a source electrode and a drain electrode which are arranged in separation from each other on the semiconductor layer; and a gate electrode placed at a position where the gate electrode can apply a bias potential to a region of the semiconductor layer positioned between the source electrode and the drain electrode.

### SUMMARY

In this disclosure, a thin-film transistor, an array substrate, a display apparatus, and a method of fabricating the array substrate are provided, which can increase the acid tolerance of the semiconductor layers of the TFTs and can reduce the cost of fabricating the TFTs.

In an aspect, an oxide semiconductor material is provided in the disclosure. The oxide semiconductor material has an etching rate of > 100 nm/min in a 5% (molar concentration) hydrogen chloride (HCl) solution prior to annealing and an etching rate of < 50 nm/min in the 5% (molar concentration) HCl solution after annealing.

The annealing is at about 200 °C - 500 °C for about 20 min - 120 min.

The oxide semiconductor layer has a thickness of 10 nm - 200 nm and a carrier concentration between 1 x 10¹⁵cm⁻³ and 1 x 10¹⁹ cm⁻³.

The oxide semiconductor layer includes substantially no indium.

The oxide semiconductor material is Sn-doped ZrO₂.

A mass percentage of Sn doped in the ZrO₂ is about 1% - 95%.

In the embodiments, the mass percentage of Sn doped in the ZrO₂ is about 50% 90%.

In some embodiments, the mass percentage of Sn doped in the ZrO₂ is about 50%.

In another aspect, a thin-film transistor (TFT) is provided in the disclosure, which comprises a semiconductor layer, and the semiconductor layer comprises the oxide semiconductor material as described above. In the embodiments of the thin-film transistor (TFT), the material of Sn-doped ZrO₂ is a major composition of the semiconductor layer.

In the embodiments, the semiconductor layer comprises a channel layer.

In some embodiments, the thin-film transistor (TFT) may be a bottom-gate type of TFT, which besides the semiconductor layer as described above, also includes a substrate, a gate electrode, a gate electrode insulating layer, a source electrode, and a drain electrode. The substrate is disposed at a bottom of the thin-film transistor; the gate electrode is sandwished between the substrate and the gate electrode insulating layer; the semiconductor layer is arranged over the gate electrode insulating layer; and the source electrode and the drain electrode are both arranged over the semiconductor layer and are separated from each other.

In some embodiments, the thin-film transistor (TFT) may be a top-gate type of TFT, which besides the semiconductor layer as described above, also includes a substrate, a gate electrode, a gate electrode insulating layer, a source electrode, and a drain electrode. The substrate is disposed at a bottom of the thin-film transistor; the source electrode and the drain electrode are arranged over the substrate and are separated from each other; the semiconductor layer is arranged over the source electrode and the drain electrode; the gate electrode insulating layer is disposed over the semiconductor layer; and the gate electrode is arranged over the gate electrode insulating layer.

In another aspect, the thin-film transistor (TFT) comprising a semiconductor layer, wherein the semiconductor layer consist substantially of a material of Sn-doped ZrO₂.

In another aspect, a display apparatus is provided comprising the thin-film transistor (TFT) as described above.

In another aspect, a method for fabricating a thin-film transistor according to claim 5 is provided, comprising: (i) forming a semiconductor layer, wherein the semiconductor layer comprises Sn-doped ZrO₂; and (ii) annealing the semiconductor layer.

In some embodiments, the method further includes, after step (ii), a step (iii): forming a source electrode and a drain electrode, wherein the source electrode and the drain electrode are formed by wet etching without use of an etching barrier layer.

In some embodiments, the method further includes, after step (ii), a step (iii): forming a gate electrode insulating layer, wherein the gate electrode insulating layer is formed by anodization without use of an electrolyte barrier layer.

In some embodiments, step (i) comprises: (a) forming a layer of Sn-doped ZrO₂; and (b) etching the layer of Sn-doped ZrO₂ to form the semiconductor layer.

In some embodiments, in sub-step (a), the layer of Sn-doped ZrO₂ is formed by physical vapor deposition (PVD).

In some embodiments, in sub-step (a), the layer of Sn-doped ZrO₂ is formed by sputtering.

In some embodiments, in sub-step (b), the layer of Sn-doped ZrO₂ is etched by an acid solution.

In some embodiments, in sub-step (b), the layer of Sn-doped ZrO₂ is etched by a 5% HCl solution in molar concentration.

In some embodiments, step (ii) comprises: annealing the semiconductor layer at about 200 °C - 500 °C for about 20 min - 120 min.

In some embodiments, step (ii) comprises: annealing the semiconductor layer at about 350 °C for about 30 min.

In the embodiments of the method, the mass percentage of Sn doped in ZrO₂ is about 50% -90%.

In another aspect, a method is provided for fabricating an array substrate with a bottom-gate thin-film transistor, comprising: (1) forming at least one gate line and at least one gate electrode over a substrate; (2) forming a gate electrode insulating layer over each of the at least one gate electrode; (3) forming a semiconductor layer over the gate electrode insulating layer, wherein the semiconductor layer comprises Sn-doped ZrO₂; (4) annealing the semiconductor layer; and (5) forming at least one data line and at least one pair of interlacing source and drain electrodes over the semiconductor layer.

In another aspect, a method is provided for fabricating an array substrate with a top-gate TFT, comprising the steps of: (1) forming at least one data line and at least one pair of interlacing source and drain electrodes over a substrate; (2) forming a semiconductor layer over each of the at least one pair of interlacing source and drain electrodes, wherein the semiconductor layer comprises Sn-doped ZrO₂; (3) annealing the semiconductor layer; (4) forming a gate electrode insulating layer over the semiconductor layer; and (5) forming at least one gate electrode and at least one gate line over the gate electrode insulating layer.

Other aspects and embodiments may become apparent in view of the following.

### BRIEF DESCRIPTION OF DRAWINGS

To more clearly illustrate some of the embodiments, the following is a brief description of the drawings. The drawings in the following descriptions are only illustrative of some embodiments. For those of ordinary skill in the art, without the premise of inventive efforts, other drawings of other embodiments can become apparent based on these drawings.
FIG. 1 is a cross-sectional view of an array substrate according to some embodiments;
FIG. 2 is a cross-sectional view of an array substrate according to some other embodiments;
FIG. 3 is a flow chart of a method for fabricating an array substrate according to a first embodiment;
FIG. 4 is a flow chart of a method for fabricating an array substrate according to a second embodiment;
FIG. 5 is a flow chart of a method for fabricating an array substrate according to a third embodiment;
FIG. 6 illustrates a correlation between carrier mobility and Sn mass percentage correlation in semiconductor layers according to some embodiments of the disclosure.

### DETAILED DESCRIPTION

In the following, with reference to the drawings of various embodiments disclosed herein, the technical solutions of the embodiments of the disclosure will be described in a clear and fully understandable way. It is obvious that the described embodiments are merely a portion but not all of the embodiments of the disclosure. Based on the described embodiments of the disclosure, those ordinarily skilled in the art can obtain other embodiment(s), without any inventive work, which come(s) within the scope sought for protection by the disclosure.

To increase acid tolerance of semiconductor layers in TFTs, and to reduce the cost of fabricating TFTs, the present disclosure provides a TFT, an array substrate, a display apparatus, and a method for fabricating an array substrate.

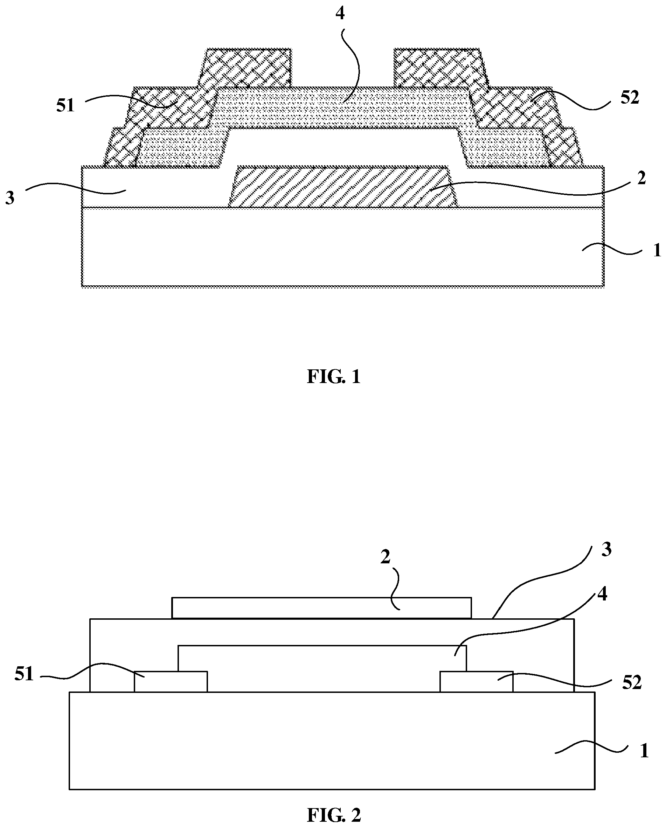

In an aspect, a TFT is provided and illustrated in FIG. 1. The TFT includes a semiconductor layer 4, and the semiconductor layer 4 comprises Sn-doped ZrO₂.

The TFT also includes a gate electrode 2, a gate electrode insulating layer 3, a source electrode 51, and a drain electrode 52, wherein the source electrode 51 and the drain electrode 52 are separated and are arranged over the semiconductor layer 4. According to some embodiments, the semiconductor layer 4 that comprises Sn-doped ZrO₂ has a high tolerance to acids after annealing, thereby allowing for wet etching to form the source electrode and drain electrode. Compared with conventional technologies, various embodiments disclosed herein can eliminate or relax the needs for an etching barrier layer during the fabrication of TFTs, thereby simplifying the fabrication processes and reducing the fabrication cost. In addition, the dopant Sn can modulate the energy band structure and alter the band gap of ZrO₂, allowing for easier generation of carriers. As such, the conductivity of the semiconductor layer can also be increased.

According to some embodiments, the semiconductor layer contains no indium, thereby also greatly reducing the fabrication cost of TFTs.

In the embodiments, the mass percentage of Sn doped in ZrO₂ is about 50% - 90%.

In some embodiments, Sn-doped ZrO₂ can be prepared by physical vapor deposition (PVD). After the PVD process, the Sn-doped ZrO₂ can be amorphous. with a Sn doping mass percentage of about 1% - 95%, the Sn-doped ZrO₂ has an etching rate of > 100 nm/min in a 5% (molar concentration) hydrogen chloride (HCl) solution. With a Sn doping mass percentage of about 10% - 90%, the Sn-doped ZrO₂ has an etching rate of > 200 nm/min in a 5% (molar concentration) HCl solution. Because of these characteristics, Sn-doped ZrO₂ is suitable for patterning by wet etching using the 5% (molar concentration) HCl solution in the fabrication process for the semiconductor layer 4 for TFTs.

The semiconductor layer can further undergo an annealing process at a temperature of about 200 °C - 500 °C for about 20 min - 120 min, to subsequently become crystalline. Its tolerance to acid etching can become even stronger. A semiconductor layer doped with 1% - 95% of Sn has an etching rate of < 50 nm/min in the 5% (molar concentration) HCl solution, and a semiconductor layer doped with 10% - 90% of Sn has an etching rate of < 20 nm/min in the 5% (molar concentration) HCl solution.

Because of the acid tolerance of the semiconductor layer after annealing, a metal electrode layer can be fabricated over the surface of the semiconductor layer of the TFTs, where the surface of the metal electrode layer can be treated with the 5% (molar concentration) HCl solution for patterning by wet etching. Soure electrodes and drain electrodes can therefore be formed without affecting structure of the semiconductor layer.

In contrast, due to its relatively high acid sensitivity, a semiconductor layer manufactured by conventional approaches may be unsuitable for forming soure electrodes and drain electrodes on its surface through wet-etching-based patterning. As such, an etching barrier layer is typically added on the surface of the semiconductor layer to protect the semiconductor layer from being damaged by the etching solution in the conventional approaches. Therefore, the embodiments disclosed herein can have one or more advantages over the conventional approach by simplifying the fabrication process and reducing the fabrication cost.

In some embodiments, the mass percentage of Sn doped in ZrO₂ is about 50%. In some other embodiments, the mass percentage of Sn doped in ZrO₂ can be 90%.

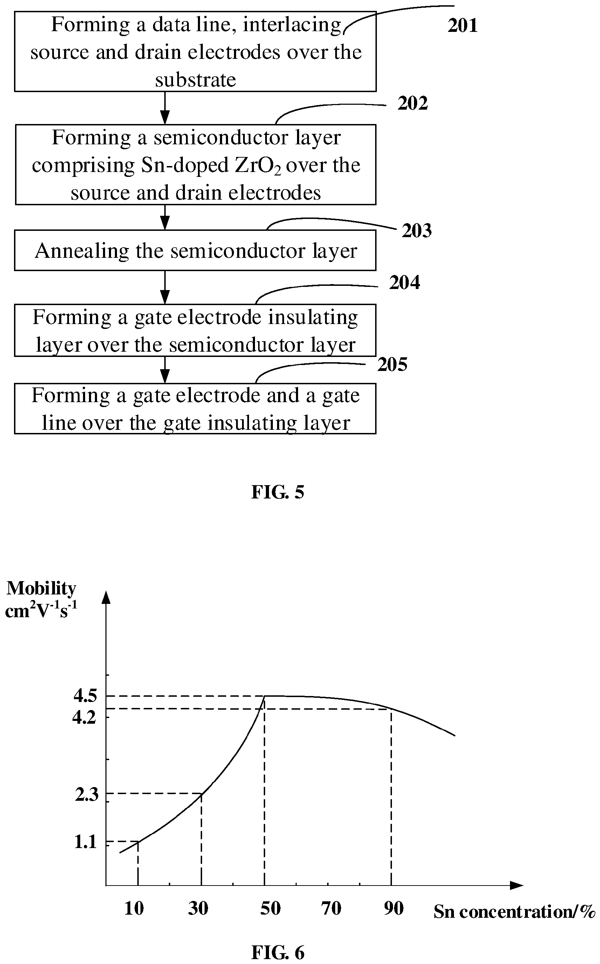

FIG. 6 illustrates a correlation between the carrier mobility and the Sn mass percentage in semiconductor layers according to some embodiments. For example, four 40-nm thick layers of Sn-doped ZrO₂, having Sn mass percentages of 10%, 30%, 50%, and 90%, respectively, can be fabricated by sputtering. The four different layers can then undergo wet-etching-based patterning, followed by annealing at 350 °C for 30 min.

A Mo electrode layer can be fabricated, and further treated by patterning using wet etching to form a source electrode and a drain electrode. Experiments indicate that the carrier mobility is about 1.1 cm²V⁻¹s⁻¹ in ZrO₂ doped with 10% of Sn, and 2.3 cm²V⁻¹s⁻¹, 4.5 cm²V⁻¹s⁻¹, and 4.2 cm²V⁻¹s⁻¹ in ZrO₂ doped with 30%, 50%, and 90% of Sn, respectively. As can be seen in FIG. 6, the carrier mobility can reach a peak at about 50% of Sn mass percentage. The semiconductor layers comprising ZrO₂ doped with 10%, 30%, 50%, or 90% of Sn thus have a relatively high carrier mobility and improved conductivity.

In some embodiments, the gate electrode 2 can comprise a conductive material, such as a metal, a metal alloy, a conductive metal oxide, or can comprise more than two layers of conductive materials, such as Mo/Al/Mo, etc. The thickness of the gate electrode 2 can be 50 nm - 1000 nm.

Materials for the gate electrode insulating layer 3 can comprise one or more layers of dielectric material, such SiO₂, SiNₓ, Si-O-N, Al₂O₃, Ta₂O₅, Y₂O₃,or HfO₂. The thickness of the gate electrode insulating layer can be 0 nm - 1000 nm.

The source electrode 51 and the drain electrode 52 can comprise a conductive material, such as a metal, a metal alloy, a conductive metal oxide, or can comprise more than two layers of conductive materials, such as Mo/Al/Mo, etc. The thickness of the source electrode and the thickness of the drain electrode can be 50 nm - 1000 nm. The semiconductor layer can be fabricated by direct sputtering or co-sputtering.

In some embodiments, the semiconductor layer can have a thickness of 10 nm - 100 nm, and a carrier concentration between 1 x 10¹⁵ cm⁻³ and 1 x 10¹⁹ cm⁻³ to thereby have a relatively high conductivity.

In some embodiments, an array substrate is provided including the TFT according to any of the embodiments as described above. The fabrication process of the array substrate can be a relatively simple and low-cost process.

An array substrate disclosed herein can comprise a bottom-gate TFT, as illustrated in FIG. 1, or a top-gate TFT, as illustrated in FIG. 2. The array substrates as shown in FIG. 1 and FIG. 2 can also include a substrate 1, and the various embodiments of the TFTs can be arranged in a matrix over the substrate 1. The material for the substrate 1 can include glass, plastic, or surface-oxidized silicon, etc.

In some embodiments, a display apparatus is provided including the array substrate according to any of the embodiments as described above. The fabrication process of the display apparatus according to the embodiments disclosed herein can be relatively simple and have lower costs as compared with conventional approaches.

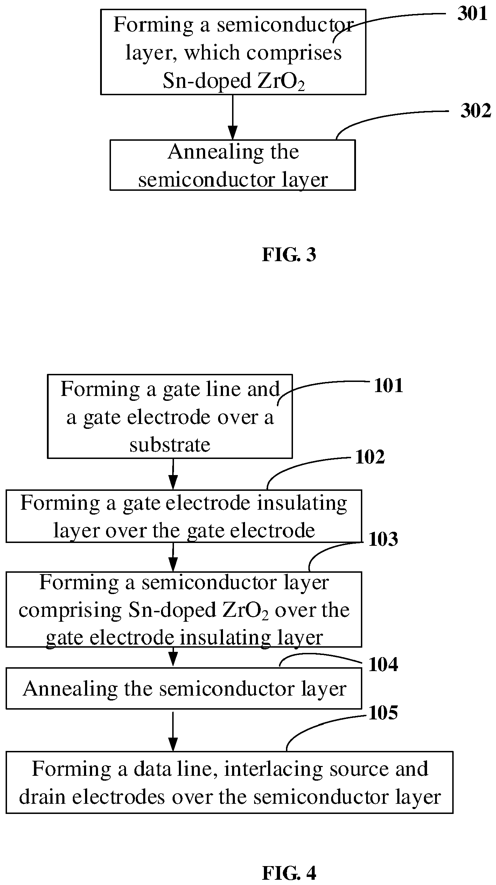

This disclosure also provides a method for fabricating a thin-film transistor (TFT) according to some embodiments, as illustrated by FIG. 3. The method can include:
Step 301: forming a semiconductor layer, which comprises Sn-doped ZrO₂;
Step 302: annealing the semiconductor layer.

More specifically, Step 301 can comprise the sub-steps of: forming a layer of Sn-doped ZrO₂; and etching the layer of Sn-doped ZrO₂ using a 5% (molar concentration) of HCl solution to form the semiconductor layer.

Step 302 can comprise the sub-step of: annealing the semiconductor layer at 200 °C - 500 °C for 20 min - 120 min.

In some embodiments, Step 302 comprises the sub-step of: annealing the semiconductor layer at 350 °C for 30 min.

The mass percentage of Sn doped in ZrO₂ has a range of 1% - 95%, where the layer of Sn-doped ZrO₂ has an etching rate of > 100 nm/min in a 5% (molar concentration) HCl solution, and has an etching rate of < 50 nm/min in a 5% (molar concentration) HCl solution after annealing.

The mass percentage of Sn doped in ZrO₂ is about 10% -90%, where the layer of Sn-doped ZrO₂ has an etching rate of > 200 nm/min in 5% (molar concentration) HCl solution, and has an etching rate of < 20 nm/min in 5% (molar concentration) HCl solution after annealing of the semiconductor layer.

FIG. 4 is a flowchart of a method for fabricating an array substrate with a bottom-gate TFT, the method comprising:
Step 101: forming a gate line and a gate electrode over a substrate;
Step 102: forming a gate electrode insulating layer over the gate electrode;
Step 103: forming a semiconductor layer comprising Sn-doped ZrO₂ over the gate electrode insulating layer;
Step 104: annealing the semiconductor layer;
Step 105: forming a data line, interlacing source and drain electrodes over the semiconductor layer.

In array substrates fabricated by the above approach, their TFTs have a semiconductor layer with high acid tolerance, and a low fabrication cost.

FIG. 5 is a flowchart of a method for fabricating an array substrate with a top-gate TFT, the method comprising:
Step 201: forming a data line, interlacing source and drain electrodes over a substrate;
Step 202: forming a semiconductor layer comprising Sn-doped ZrO₂ over the source and drain electrodes;
Step 203: annealing the semiconductor layer;
Step 204: forming a gate electrode insulating layer over the semiconductor layer;
Step 205: forming a gate electrode and a gate line over the gate insulating layer.

In array substrates fabricated with the above method, the TFTs have a semiconductor layer with a high acid tolerance, and a low fabrication cost.

In this method, Sn-doped ZrO₂ has a relatively poor acid tolerance prior to annealing. Based on this characteristic, during fabrication of TFTs, wet-etching-based patterning can be employed to form the semiconductor layer of the TFTs.

The semiconductor layer can subsequently undergo an annealing treatment at 200 °C - 500 °C for 20 min - 120 min. The gate electrode insulating layer can be generated by anodization, in which an acid solution can be used as the anodizing electrolyte solution.

Based on the acid tolerance of the semiconductor layer after annealing, a gate electrode insulating layer can thereby be fabricated over the surface of the semiconductor layer of the TFTs without affecting the structure of the semiconductor layer.

In contrast, due to its relatively high acid sensitivity, the semiconductor layer manufactured by conventional approaches may be unsuitable for forming the gate electrode insulating layer on its surface by anodization. As a result, an electrolyte barrier layer is typically added over the surface of the semiconductor layer to protect the semiconductor layer from being damaged by the electrolyte solution.

Although in some embodiments the annealing temperature can be 200 °C - 500 °C, such as 350 °C, those of ordinary skill in the art will recognize that other annealing temperatures may be possible. Similarly, although in some embodiments the annealing time of 20 min - 120 min, such as 30 min, is disclosed, other annealing time may be possible.

In some embodiments, a method for preparing an array substrate is provided including the following steps, though those of ordinary skill in the art will recognize that specific steps according to various embodiments are not limited by this example method.
Step 1): fabricating a metal film over a substrate by sputtering, and performing photolithography to the metal film to form a gate electrode 2;
Step 2): forming a gate electrode insulating layer 3 over an upper surface of the gate electrode 2 by anodization;
Step 3): fabricating a layer of Sn-doped ZrO₂ by sputtering over a surface of the gate electrode insulating layer 3, and treating the layer of Sn-doped ZrO₂ to form a semiconductor layer 4 by wet-etching-based patterning;
Step 4): annealing the semiconductor layer 4;
Step 5): fabricating a metal electrode layer over a surface of the semiconductor layer 4, and forming a source electrode 51 and a drain electrode 52 over the metal electrode layer by wet etching using an acid etching solution.

For example, an Al-Nd film with a thickness of about 300 nm can be fabricated over a glass substrate 1 by sputtering, which can then undergo photolithography to form a gate electrode 2. A gate electrode insulating layer 3 is formed next by anodization and is configured to be about 200 nm thick.

A semiconductor layer 4, which comprises a layer of Sn-doped ZrO₂, is then fabricated over the surface of the gate electrode insulating layer 3 by sputtering, using a metal mask for patterning, followed by annealing at 350 °C for 30 min.

An Al film with a thickness of about 200 nm can be fabricated next over the surface of the semiconductor layer 4 by sputtering, followed by wet-etching-based patterning using 5% (molar concentration) of HCl solution and a metal mask to form a source electrode 51 and a drain electrode 52. In some embodiments, a Mo film can be fabricated in a similar manner as the Al film as described above.

In some embodiments, the semiconductor layer 4 is a channel layer. The etching process described above comprises a back-channel etching to form the semiconductor layer.

## Claims

1. A thin-film transistor (TFT), comprising a semiconductor layer, wherein the semiconductor layer comprises a channel layer and comprises a material of Sn-doped ZrO₂, the material of Sn-doped ZrO₂ is a major composition of the semiconductor layer, and a mass percentage of Sn doped in the ZrO₂ is about 50% - 90%.

2. The thin-film transistor (TFT) of Claim 1, further comprising a substrate, a gate electrode, a gate electrode insulating layer, a source electrode, and a drain electrode, wherein:
the substrate is disposed at a bottom of the thin-film transistor;
the gate electrode is sandwished between the substrate and the gate electrode insulating layer;
the semiconductor layer is arranged over the gate electrode insulating layer; and
the source electrode and the drain electrode are both arranged over the semiconductor layer and are separated from each other.

3. The thin-film transistor (TFT) of Claim 1, further comprising a substrate, a gate electrode, a gate electrode insulating layer, a source electrode, and a drain electrode, wherein:
the substrate is disposed at a bottom of the thin-film transistor;
the source electrode and the drain electrode are arranged over the substrate and are separated from each other;
the semiconductor layer is arranged over the source electrode and the drain electrode;
the gate electrode insulating layer is disposed over the semiconductor layer; and
the gate electrode is arranged over the gate electrode insulating layer.

4. A display apparatus, comprising a thin-film transistor (TFT) according to any one of Claims 1-3.

5. A method for fabricating a thin-film transistor (TFT), comprising:
(i) forming a semiconductor layer, wherein the semiconductor layer comprises a channel layer and comprises a material of Sn-doped ZrO₂, the material of Sn-doped ZrO₂ is a major composition of the semiconductor layer, and a mass percentage of Sn doped in the ZrO₂ is about 50% - 90%; and
(ii) annealing the semiconductor layer.

6. The method of Claim 5, further comprising, after step (ii), a step of:
(iii) forming a source electrode and a drain electrode, wherein the source electrode and the drain electrode are formed by wet etching without use of an etching barrier layer.

7. The method of Claim 5, further comprising, after step (ii), a step of:
(iii) forming a gate electrode insulating layer, wherein the gate electrode insulating layer is formed by anodization without use of an electrolyte barrier layer.

8. The method of Claim 5, wherein step (i) comprises:
(a) forming a layer of Sn-doped ZrO₂; and
(b) etching the layer of Sn-doped ZrO₂ to form the semiconductor layer.

9. The method of Claim 8, wherein in sub-step (a), the layer of Sn-doped ZrO₂ is formed by physical vapor deposition (PVD).

10. The method of Claim 9, wherein in step (a), the layer of Sn-doped ZrO₂ is formed by physical vapor deposition (PVD) by sputtering .

11. The method of Claim 8, wherein in sub-step (b), the layer of Sn-doped ZrO₂ is etched by an acid solution.

12. The method of Claim 11, wherein the acid solution is a 5% HCl solution, wherein 5% is a molar concentration .

13. The method of Claim 5, wherein step (ii) comprises: annealing the semiconductor layer at about 200 °C - 500 °C for about 20 min - 120 min.

14. The method of Claim 13, wherein step (c) comprises: annealing the semiconductor layer at about 350 °C for about 30 min.

## Patentansprüche

1. Dünnschichttransistor (TFT), eine Halbleiterschicht aufweisend, wobei die Halbleiterschicht eine Kanalschicht aufweist und ein Material aus Sn-dotiertem ZrO₂ aufweist, das Material aus Sn-dotiertem ZrO₂ eine Hauptzusammensetzung der Halbleiterschicht ist und ein Massenprozentsatz von Sn, das in das ZrO₂ dotiert ist, etwa 50 % - 90 % beträgt.

2. Dünnschichttransistor (TFT) nach Anspruch 1, ferner ein Substrat, eine Gate-Elektrode, eine Gate-Elektrodenisolierschicht, eine Source-Elektrode und eine Drain-Elektrode aufweisend, wobei:
das Substrat an einem Boden des Dünnschichttransistors angeordnet ist;
die Gate-Elektrode sandwichartig zwischen dem Substrat und der Gate-Elektrodenisolierschicht angeordnet ist;
die Halbleiterschicht über der Gate-Elektrodenisolierschicht angeordnet ist; und
die Source-Elektrode und die Drain-Elektrode beide über der Halbleiterschicht angeordnet sind und voneinander getrennt sind.

3. Dünnschichttransistor (TFT) nach Anspruch 1, ferner ein Substrat, eine Gate-Elektrode, eine Gate-Elektrodenisolierschicht, eine Source-Elektrode und eine Drain-Elektrode aufweisend, wobei:
das Substrat an einer Unterseite des Dünnschichttransistors angeordnet ist;
die Source-Elektrode und die Drain-Elektrode über dem Substrat angeordnet sind und voneinander getrennt sind;
die Halbleiterschicht über der Source-Elektrode und der Drain-Elektrode angeordnet ist;
die Gate-Elektrodenisolierschicht über der Halbleiterschicht angeordnet ist; und
die Gate-Elektrode über der Gate-Elektrodenisolierschicht angeordnet ist.

4. Anzeigevorrichtung, einen Dünnschichttransistor (TFT) nach einem der Ansprüche 1 - 3 aufweisend.

5. Verfahren zur Herstellung eines Dünnschichttransistors (TFT), umfassend:
(i) Bilden einer Halbleiterschicht, wobei die Halbleiterschicht eine Kanalschicht aufweist und ein Material aus Sn-dotiertem ZrO₂ aufweist, wobei das Material aus Sn-dotiertem ZrO₂ eine Hauptzusammensetzung der Halbleiterschicht ist und ein Massenprozentsatz von Sn, das in das ZrO₂ dotiert ist, etwa 50 % - 90 % beträgt; und
(ii) Tempern der Halbleiterschicht.

6. Verfahren nach Anspruch 5, ferner nach Schritt (ii) einen folgenden Schritt umfassend:
(iii) Bilden einer Source-Elektrode und einer Drain-Elektrode, wobei die Source-Elektrode und die Drain-Elektrode durch Nassätzen ohne Verwendung einer Ätzsperrschicht gebildet werden.

7. Verfahren nach Anspruch 5, ferner nach Schritt (ii) einen folgenden Schritt umfassend:
(iii) Bilden einer Gate-Elektrodenisolierschicht, wobei die Gate-Elektrodenisolierschicht durch Anodisierung ohne Verwendung einer Elektrolytsperrschicht gebildet wird.

8. Verfahren nach Anspruch 5, wobei Schritt (i) umfasst:
(a) Bilden einer Schicht aus Sn-dotiertem ZrO₂; und
(b) Ätzen der Schicht aus Sn-dotiertem ZrO₂, um die Halbleiterschicht zu bilden.

9. Verfahren nach Anspruch 8, wobei in Unterschritt (a) die Schicht aus Sn-dotiertem ZrO₂ durch physikalische Dampfabscheidung (PVD) gebildet wird.

10. Verfahren nach Anspruch 9, wobei in Schritt (a) die Schicht aus Sn-dotiertem ZrO₂ durch physikalische Gasphasenabscheidung (PVD) durch Sputtern gebildet wird.

11. Verfahren nach Anspruch 8, wobei in Unterschritt (b) die Schicht aus Sn-dotiertem ZrO₂ durch eine Säurelösung geätzt wird.

12. Verfahren nach Anspruch 11, wobei die Säurelösung eine 5 %ige HCl-Lösung ist, wobei 5 % eine molare Konzentration ist.

13. Verfahren nach Anspruch 5, wobei Schritt (ii) umfasst: Tempern der Halbleiterschicht bei etwa 200 °C - 500 °C für etwa 20 Min. - 120 Min.

14. Verfahren nach Anspruch 13, wobei Schritt (c) umfasst: Tempern der Halbleiterschicht bei etwa 350 °C für etwa 30 Min.

## Revendications

1. Transistor à couche mince (TFT), comprenant une couche semi-conductrice, dans laquelle la couche semi-conductrice comprend une couche de canal et comprend un matériau de ZrO₂ dopé à l'étain, le matériau de ZrO₂ dopé à l'étain est une composition majeure de la couche semi-conductrice, et un pourcentage en masse de dopage à l'étain dans la ZrO₂ est d'environ 50% à 90%.

2. Transistor à couche mince (TFT) selon la revendication 1, comprenant en outre un substrat, une électrode de grille, une couche isolante d'électrode de grille, une électrode de source, et une électrode de drain, dans laquelle :
le substrat est disposé au fond du transistor à couche mince ;
l'électrode de grille est pris en sandwich entre le substrat et la couche isolante d'électrode de grille ;
la couche semi-conductrice est disposée sur la couche isolante d'électrode de grille ; et
l'électrode de source et l'électrode de drain sont tous les deux disposées sur la couche semi-conductrice et sont séparées les unes des autres.

3. Transistor à couche mince (TFT) selon la revendication 1, comprenant en outre un substrat, une électrode de grille, une couche isolante d'électrode de grille, une électrode de source et une électrode de drain, dans laquelle :
le substrat est disposé au fond du transistor à couche mince ;
l'électrode de source et l'électrode de drain sont disposées sur le substrat et sont séparées les unes des autres ;
la couche semi-conductrice est agencée sur l'électrode de source et l'électrode de drain ;
la couche isolante d'électrode de grille est disposée sur la couche semi-conductrice ; et
l'électrode de grille est agencée sur la couche isolante d'électrode de grille.

4. Appareil d'affichage, comprenant un transistor à couche mince (TFT) selon l'une quelconque des revendications 1 à 3.

5. Procédé de fabrication d'un transistor à couche mince (TFT), comprenant l'étape consistant à :
(i) former une couche semi-conductrice, dans laquelle la couche semi-conductrice comprend une couche de canal et comprend un matériau de ZrO₂ dopé à l'étain, le matériau de ZrO₂ dopé à l'étain est une composition majeure de la couche semi-conductrice, et un pourcentage en masse de dopage à l'étain dans le ZrO₂ est d'environ 50% à 90% ; et (ii) recuire la couche semi-conductrice.

6. Procédé selon la revendication 5, comprenant en outre, après l'étape (ii), une étape consistant à :
(iii) former une électrode de source et une électrode de drain, dans laquelle l'électrode de source et l'électrode de drain sont formées par gravure humide sans utilisation d'une couche barrière de gravure.

7. Procédé selon la revendication 5, comprenant en outre, après l'étape (ii), une étape consistant à :
(iii) former une couche isolante d'électrode de grille, dans laquelle la couche isolante d'électrode de grille est formée par anodisation sans utilisation d'une couche barrière d'électrolyte.

8. Procédé selon la revendication 5, dans lequel l'étape (i) comprend les étapes consistant à :
(a) former une couche de ZrO₂ dopé à l'étain ; et
(b) graver la couche de ZrO₂ dopé à l'étain pour former la couche semi-conductrice.

9. Procédé selon la revendication 8, dans lequel dans la sous-étape (a), la couche de ZrO₂ dopé à l'étain est formée par dépôt de vapeur physique (PVD).

10. Procédé selon la revendication 9, dans lequel, à l'étape (a), la couche de ZrO₂ dopé à l'étain est formée par dépôt de vapeur physique (PVD) par pulvérisation.

11. Procédé selon la revendication 8, dans lequel dans la sous-étape (b), la couche de ZrO₂ dopé à l'étain est gravée par une solution acide.

12. Procédé selon la revendication 11, dans lequel la solution acide est une solution de HCl à 5%, dans laquelle 5% est une concentration molaire.

13. Procédé selon la revendication 5, dans lequel l'étape (ii) comprend l'étape consistant à : recuire la couche semi-conductrice à environ 200 °C à 500 °C pendant environ 20 min à 120 minutes.

14. Procédé selon la revendication 13, dans lequel l'étape (c) comprend l'étape consistant à : recuire la couche semi-conductrice à environ 350 °C pendant environ 30 min.
